# EUROPÄISCHE PATENTSCHRIFT

(11) **EP 1 438 881 B1**
(45) Veröffentlichungstag und Bekanntmachung des Hinweises auf die Patenterteilung: **18.05.2005**
(21) Anmeldenummer: 02776754.0
(22) Anmeldetag: 30.09.2002
(51) Int. Cl.: H05K 3/40

(54) **GRÜNER KERAMISCHER EINSATZKÖRPER, KERAMISCHER EINSATZKÖRPER, KERAMISCHER GRÜNKÖRPER ODER GRÜNKÖRPERVERBUND UND DAMIT HERGESTELLTER KERAMISCHER SCHICHTVERBUND**
GREEN CERAMIC INSERT, CERAMIC INSERT, CERAMIC GREEN BODY OR GREEN BODY COMPOSITE AND CERAMIC LAMINATED COMPOSITE PRODUCED THEREBY
INSERT CERAMIQUE CRU, INSERT CERAMIQUE, CORPS CRU CERAMIQUE OU ENSEMBLE DE CORPS CRUS ET COMPOSITE CERAMIQUE STRATIFIE PRODUIT A PARTIR DE CE DERNIER

(30) Priorität: 13.10.2001 DE 10150715
(43) Veröffentlichungstag der Anmeldung: 21.07.2004
(73) Patentinhaber: ROBERT BOSCH GMBH, 70442 Stuttgart (DE)
(72) Erfinder: DE LA PRIETA, Claudio, 70569 Stuttgart (DE); HACHTEL, Andreas, 70771 Leinfelden-Echterdingen (DE); SCHULTE, Thomas, 70376 Stuttgart (DE); GLANZ, Uwe, 71679 Asperg (DE); HIRTH, Erhard, 74248 Ellhofen (DE)
(86) Internationale Anmeldenummer: PCT/DE2002/003699
(87) Internationale Veröffentlichungsnummer: WO 2003/034446

(56) Entgegenhaltungen:
- DE-A- 19 742 072
- GB-A- 1 424 642
- US-A- 3 077 511
- US-A- 5 169 310
- DATABASE WPI Week 199336 Derwent Publications Ltd., London, GB; AN 1993-283739 XP002263769 & JP 05 198700 A (FUJITSU)

## Beschreibung

Die Erfindung betrifft einen grünen keramischen Einsatzkör-per, einen daraus gesinterten keramischen Einsatzkörper, einen keramischen Grünkörper oder einen Verbund keramischer Grünkörper sowie einen daraus hergestellten gesinterten keramischen Schichtverbund, nach der Gattung der unabhängigen Ansprüche.

### Stand der Technik

Bei der Herstellung planarer Abgassonden wie beispielsweise üblicher Lambda-Sonden in Dickschichttechnologie werden vielfach elektrisch isolierte Durchkontaktierungen, sogenannte "Vias", eingesetzt, um beispielsweise Leiterbahnen auf unterschiedlichen Sensorebenen oder Vorderseite und Rückseite eines keramischen Schichtverbundes miteinander verbinden zu können.

Sofern das Material, aus dem die keramischen Grünfolien bestehen, elektrisch isolierend ist, d.h. es sich beispielsweise um sogenannte LTCC-Keramik auf Basis von Al₂O₃ handelt (LTCC = "Low Temperature Co-fired Ceramic"), wird dabei einfach ein Loch in die keramische Grünfolie gebohrt oder gestanzt, und mit einer mit einem leitfähigen Material wie Silber oder Platin gefüllten Paste gefüllt, wie sie zur Herstellung von Leiterbahnen allgemein üblich sind.

Das Dokument GB-A-1424 642 offenbart einen Einsatzkörper aus einem mit Metallsilikaten beschichteten Metalldalit der in eine Ausnehmung eines keramishen Substrats eingesteckt wird.

Schwieriger ist der Aufbau einer isolierten Durchkontaktierung, die für elektrisch zumindest schwach leitende Folienmaterialien wie beispielsweise yttriumstabilisiertes Zirkoniumdioxid geeignet ist.

Um im Fall von yttriumstabilisierten, zirkoniumdioxidhaltigen keramischen Grünfolien, aus denen nach dem Sintern eine yttriumstabilisierte Zirkoniumdioxid-Keramik entsteht, eine von dem Folienmaterial isolierte elektrische Durchkontaktierung realisieren zu können, wurde vorgeschlagen, eine platinhaltige Paste zu verwenden, der Nioboxid (Nb₂O₅) zugesetzt ist. Dieses ist in der Lage, die Dotierung des Zirkoniumdioxids durch das Yttriumoxid zu kompensieren, wodurch in der Umgebung der Via bzw. der elektrischen Durchführung eine Stöchiometrie innerhalb des Ionenleiters "yttriumstabilisiertes Zirkoniumdioxid" resultiert, die sich durch eine vergleichsweise geringe elektrische Leitfähigkeit auszeichnet.

Eine weitere Möglichkeit, elektrisch isolierte Durchführungen in leitfähige keramische Mehrlagenstrukturen zu integrieren, besteht darin, zunächst ein Loch für die elektrische Durchführung in die Grünfolie(n) einzubringen, dieses Loch dann auf der Innenseiten der das Loch begrenzenden Wand der Grünfolie(n) mit einer isolierenden Paste zu beschichten bzw. zu benetzen, und anschließend dann das leitfähige Material, d.h. beispielsweise die mit Platin gefüllte Paste, in das nun isolierte Loch einzubringen.

Nachteilig bei den erläuterten Verfahren zur Herstellung der Durchkontaktierung bzw. den bisher hergestellten Durchkontaktierungen ist, dass bei hohen Betriebstemperaturen die Gegendotierung durch Nb₂O₅ partiell unwirksam wird, so dass der Isolationswiderstand zu der elektrischen Durchführung deutlich absinkt. Weiter ist das Durchsaugen von zwei unterschiedlichen Pasten, einerseits zunächst einer Isolationspaste und andererseits danach einer Leitpaste, vor allem bei einem mehrlagigen Verbund keramischer Grünfolien bzw. einem daraus durch Sintern hergestellten keramischen Schichtverbund sehr schwierig, da kaum sicher zu stellen ist, dass die zunächst auf den Innenwänden aufgebrachte Isolationsschicht an keiner Stelle rissig ist, und somit sicher einen Kontakt der Leitpaste mit den elektrisch leitfähigen keramischen Grünfolien bzw. den daraus gesinterten keramischen Schichten verhindert.

Im Übrigen ist die Isolationswirkung bekannter isolierter elektrischer Durchführungen vor allem bei hohen Temperaturen generell gering, da die bisher eingesetzten Isolationsschichten aufgrund ihrer Herstellungsweise nur über geringe Schichtdicken verfügen.

Insgesamt ist es bisher nicht gelungen, eine sichere, hochohmige Isolation einer Via bzw. elektrischen Durchführung durch einen keramischen Schichtverbund oder eine Keramikschicht auch bei höchsten Einsatztemperaturen zu gewährleisten.

### Vorteile der Erfindung

Der erfindungsgemäße grüne keramische Einsatzkörper, der daraus gesinterte keramische Einsatzkörper, der erfindungsgemäße keramische Grünkörper oder Verbund keramischer Grünkörper mit einem derartigen grünen keramischen Einsatzkörper und der daraus durch Sintern hergestellte keramische Schichtverbund hat gegenüber dem Stand der Technik den Vorteil, dass damit eine sehr zuverlässige, sichere und hochwertige elektrische Isolation im Bereich einer elektrischen Durchführung bzw. Via in keramischen Schichten oder Schichtverbünden auch für Hochtemperaturanwendungen und im Fall von mehreren bzw. zahlreichen Durchkontaktierungsebenen erreichbar ist.

Vorteilhafte Weiterbildungen der Erfindung ergeben sich aus in den Unteransprüchen genannten Maßnahmen.

So ist besonders vorteilhaft, wenn der grüne keramische Einsatzkörper einen prismenförmig, quaderförmig oder bevorzugt zylinderförmig mit in Draufsicht rundum oder ellipsoidförmigen Querschnitt ausgebildeten Keramikkörper aufweist, wobei in diesen eine dazu konzentrisch geführte, insbesondere diesen durchquerende Ausnehmung eingebracht ist, die mit einer üblichen, beispielsweise durch Sintern in die elektrische Durchführung überführbaren Paste gefüllt ist.

Um eine optimale elektrische Isolation der elektrischen Durchführung gegenüber den benachbarten Bereichen des keramischen Grünkörpers oder Schichtverbundes, der beispielsweise zumindest bereichsweise aus yttriumstabilisiertem Zirkoniumdioxid besteht, zu gewährleisten, ist vorteilhaft, wenn der grüne Keramikkörper beispielsweise mittels Sintern in eine gegenüber der elektrischen Durchführung und auch dem nach dem Sintern in deren Umgebung vorliegenden keramischen Schichtverbundes elektrisch nicht oder schwach leitende Keramik, beispielsweise eine im Wesentlichen aus Al₂O₃ bestehende Keramik, überführbar ist.

Die in den grünen keramischen Einsatzkörper im Bereich der Ausnehmung eingefüllte Paste ist bevorzugt mit einem elektrisch leitfähigen Material wie Platin oder Aluminium gefüllt. Besonders bevorzugt wird diese Paste derart in die Ausnehmung in den grünen Keramikkörper eingefüllt, dass sie zumindest einseitig, vorzugsweise beidseitig, im Bereich der Austrittsöffnungen der Ausnehmung aus dem grünen Keramikkörper vorsteht bzw. diese überragt, so dass in einem nachfolgenden Verfahrensschritt diese vorstehenden Pastenbereiche in besonders einfacher und zuverlässiger Weise mit einer auf der Oberseite und/oder Unterseite aufgedruckten, insbesondere zu Leiterbahnen strukturierten Leitpaste verbunden werden kann.

Die Dimensionen der Ausnehmung in dem Keramikkörper liegt bevorzugt bei einem Durchmesser von 50 µm bis 2 mm bei einem Durchmesser des grünen Keramikkörpers von bevorzugt von 0,5 mm bis 5 mm.

Ganz besonders vorteilhaft ist weiter, wenn der keramische Grünkörper oder der Verbund keramischer Grünkörper, in den der grüne keramische Einsatzkörper eingesetzt ist oder wird, eine Aussparung aufweist, die in ihrer Dimensionierung möglichst exakt an die Form des grünen keramischen Einsatzkörpers angepasst oder geringfügig größer ist, und die bevorzugt gleichzeitig die Oberseite des Grünkörpers oder Grünkörperverbundes mit der Unterseite des Grünkörpers oder Grünkörperverbundes verbindet. In diesem Zusammenhang ist weiter vorteilhaft, wenn das Material des grünen keramischen Einsatzkörpers so an das Material des umgebenden keramischen Grünkörpers bzw. Grünkörperverbundes angepasst werden ist, dass sich das Material des grünen keramischen Einsatzkörpers nach dem Einsetzen bei einem Sintern innerhalb der Aussparung etwas ausdehnt, und sich so in der Aussparung verfestigt bzw. dort fest verankert wird. Insbesondere wird so erreicht, dass sich der grüne keramische Einsatzkörper stoffschlüssig mit dem umgebenden Grünkörper bzw. keramischen Grünkörperverbund verbindet, wobei gleichzeitig auch die durch das Sintern in eine Leiterbahn oder strukturierte Leitfläche überführte Leitpaste im Bereich der elektrischen Durchführung die Oberseite des nach dem Sintern entstandenen keramischen Schichtverbundes elektrisch leitend mit dessen Unterseite verbindet.

Durch das geringfügige Ausdehnen des Materials des grünen keramischen Einsatzkörpers wird einerseits ein fester, passgenauer Sitz in der Aussparung in dem keramischen Grünkörper bzw. Grünkörperverbund und andererseits eine gewisse Fertigungstoleranz erreicht.

Um die Haftung bzw. den Sitz des eingebrachten grünen keramischen Einsatzkörpers in dem keramischen Grünkörper bzw. Grünkörperverbund im Bereich der dort eingebrachten Aussparung weiter zu verbessern ist zudem vorteilhaft, wenn die Innenseite der Aussparung in dem keramischen Grünkörper bzw. Grünkörperverbund vor dem Einsetzen des grünen keramischen Einsatzkörpers zusätzlich zumindest bereichsweise mit einer Binderpaste oder einem Schlicker, vorzugsweise einer üblichen Folienbinderpaste, beschichtet wird.

Um auf oder auch in dem keramischen Grünkörper bzw. Grünkörperverbund bzw. dem nach dessen Sintern aus diesem entstandenen keramischen Schichtverbund Leiterbahnen oder strukturierte Leitflächen elektrisch isoliert von diesem an die entstandene elektrische Durchführung heranführen zu können, ist vorteilhaft, wenn der keramische Grünkörper oder Grünkörperverbund oder zumindest einzelne, diesen aufbauende keramische Grünfolien zumindest einseitig, insbesondere beidseitig, und zumindest bereichsweise auf Oberseite bzw. Unterseite mit einer zusätzlichen grünen keramischen Isolationsschicht versehen sind, die nach dem Sintern in keramische Isolationsschichten, beispielsweise auf Basis von Al₂O₃, übergehen.

### Zeichnung

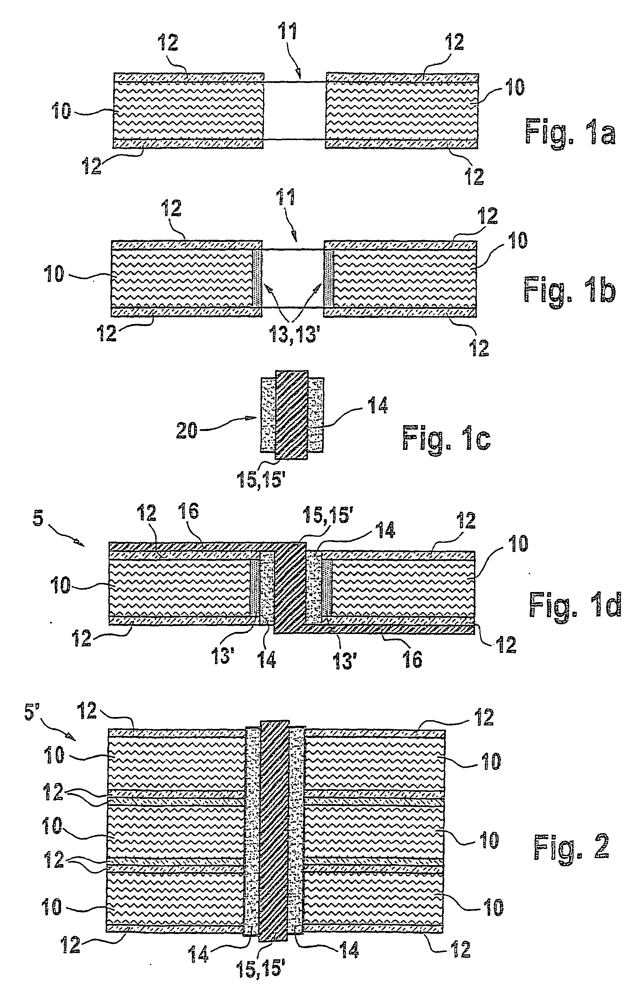

Die Erfindung wird anhand der Zeichnung und in der nachfolgenden Beschreibung näher erläutert. Es zeigen Figur 1a bis 1d verschiedene Verfahrensschritte zur Herstellung eines keramischen Grünkörpers mit einem eingesetzten grünen keramischen Einsatzkörper im Schnitt und Figur 2 ein zu Figur 1d alternatives Ausführungsbeispiel.

### Ausführungsbeispiele

In dem mit Hilfe der Figuren 1a bis 1d erläuterten ersten Ausführungsbeispiel wird eine elektrische Durchkontaktierung als sogenanntes "Inlay" zunächst separat aus einer keramischen Grünfolie hergestellt, die beispielsweise durch Sintern in ein hochisolierendes Material wie Al₂O₃ überführbar ist, wobei sich im Inneren dieses Inlays eine vor dem Sintern mit einer Paste gefüllte Ausnehmung befindet, die durch das Sintern in die elektrische Durchführung überführt wird. Das Inlay wird dann nach Art eines Stöpsels in ein beispielsweise vorgebohrtes oder vorgestanztes Loch einer keramischen Grünfolie oder auch eine Grünfolienverbundes eingeschoben, wonach auf der Oberseite bzw. der Unterseite der keramischen Grünfolie im Weiteren dann Leiterbahnen aufgedruckt werden, bevor die so entstandene Gesamtstruktur dann abschließend zu einem keramischen Schichtverbund gesintert wird.

Die Figur 1a zeigt eine übliche keramische Grünfolie 10 auf Basis von yttriumstabilisiertem Zirkoniumdioxid, die beidseitig mit einer dünnen grünen keramischen Isolationsschicht bzw. Isolationsfolie 12 versehen ist, die beispielsweise durch Sintern in eine Al₂O₃-Keramik überführbar ist. In der keramischen Grünfolie 10 ist weiter eine Aussparung 11 in Form eines zylindrischen Loches eingebracht. Dabei kann das Einbringen der Aussparung 11 in die Grünfolie 10 sowohl nach dem Aufbringen der Isolationsschichten 12 auf die Grünfolie 10 als auch vor deren Aufbringen erfolgt sein.

Die Figur 1b zeigt weiter, wie in einem nachfolgenden Verfahrensschritt im Bereich der Aussparung 11 die Innenwände 13 der Grünfolie 10 mit einer üblichen Folienbinderpaste 13' beschichtet werden.

Die Figur 1c zeigt, wie parallel oder vor oder nach den Verfahrensschritten 1a oder 1b ein grüner keramischer Einsatzkörper 20 hergestellt wird, dessen Dimension an die Dimension der Aussparung 11 angepasst ist, oder der im Durchmesser geringfügig kleiner ist. Der grüne keramische Einsatzkörper 20 ist entsprechend der Aussparung 11 zylinderförmig ausgebildet, und weist eine durchgehende Ausnehmung 15 in Form eines Loches mit kreisförmigem Querschnitt auf, das von einem ebenfalls zylinderförmig ausgebildeten grünen Keramikkörper 14 umgeben ist.

Der grüne Keramikkörper 14 ist beispielsweise aus einer keramischen Grünfolie ausgestanzt, die durch Sintern in eine elektrisch hoch isolierende Keramik, beispielsweise eine Al₂O₃-Keramik, überführbar ist.

Anschließend wird die den grünen Keramikkörper 14 durchquerende Ausnehmung 15 mit einer üblichen Paste 15' gefüllt, die mit einem elektrisch leitfähigem Material wie Platin oder Aluminium gefüllt und durch Sintern in eine elektrische Durchführung überführbar ist.

Gemäß Figur 1c ist dabei vorgesehen, dass die Paste 15' den grünen Keramikkörper 14 geringfügig beidseitig überragt.

Die Figur 1d zeigt die weiteren Verfahrensschritte, wobei der grüne keramische Einsatzkörper 20 gemäß Figur 1c in die Aussparung 11 gemäß Figur 1b eingesetzt worden ist, und wobei anschließend auf der Oberseite bzw. der Unterseite des dadurch entstandenen keramischen Grünkörpers 5 bereichsweise eine in Form von Leiterbahnen bzw. Leitschichten strukturierte, an sich bekannte Leitpaste 16 aufgedruckt worden ist. Die Leitpaste 16 ist bevorzugt identisch mit der Paste 15', die die elektrische Durchführung bildet.

Insgesamt ist somit gemäß Figur 1d ein keramischer Grünkörper 5 entstanden, bei dem die Oberseite mit der Unterseite über eine elektrische Durchführung, die im Bereich der Ausnehmung 15 vorliegt, verbunden ist, wobei diese elektrische Durchführung gleichzeitig durch den grünen Keramikkörper 14 gegenüber der Grünfolie 10 elektrisch isoliert ist. Weiter ist auch die Leitpaste 16 gegenüber der Grünfolie 10 durch die Isolationsschichten 12 isoliert.

Abschließend wird dann der keramische Grünkörper 5 gemäß Figur 1d in üblicher Weise gesintert, so dass ein keramischer Schichtverbund entsteht.

Im Übrigen sei noch angemerkt, dass aufgrund der Abmessungen und der Flexibilität der eingesetzten keramischen Grünfolien 10, 12 diese in der Regel eine ausreichende Festigkeit für die vorgesehenen Verfahrensschritte aufweisen, so dass beispielsweise das Einsetzen des grünen keramischen Einsatzkörpers 20 in die Aussparung 11 nicht mit besonderen verfahrenstechnischen Schwierigkeiten behaftet ist.

Die Figur 2 zeigt ein zweites Ausführungsbeispiel, wobei ein Verbund keramischer Grünkörper bzw. ein Grünfolienstapel 5' dargestellt ist, der aus mehreren einzelnen keramischen Grünfolien 10 mit jeweils beidseitig auf deren Oberflächen aufgebrachten Isolationsschichten 12 gemäß Figur 1b besteht.

Auch in diesem Fall ist in dem keramischen Grünkörperverbund 5' ein grüner keramischer Einsatzkörper 20 gemäß Figur 1c eingesetzt, der nun entsprechend der Höhe des Grünkörperverbundes 5' bzw. entsprechend der Aussparung 11 gemäß Figur 1b dimensioniert ist.

Insgesamt wird nach einem abschließenden Sintern des Verbundes keramischer Grünfolien 5' gemäß Figur 2 eine elektrische Durchführung in einem keramischen Schichtverbund erhalten, die mehrere Folienlagen gleichzeitig durchstößt. In Figur 2 ist im Übrigen die auch dort vorhandene aufgedruckte strukturierte Leitpaste 16 gemäß Figur 1d aus Gründen der Übersichtlichkeit nicht dargestellt.

## Patentansprüche

1. Grüner keramischer Einsatzkörper mit einem grünen,
mit einer Ausnehmung (15) versehenen Keramikkörper (14), wobei die Ausnehmung (15) den grünen Keramikkörper (14) durchquert und mit einer in eine elektrische Durchführung überführbaren Paste (15') gefüllt ist.

2. Grüner keramischer Einsatzkörper nach Anspruch 1, **dadurch gekennzeichnet, dass** der grüne Keramikkörper (14) insbesondere mittels Sintern in eine gegenüber der elektrischen Durchführung elektrisch nicht oder schwach leitende Keramik überführbar ist.

3. Grüner keramischer Einsatzkörper nach Anspruch 1 oder 2, **dadurch gekennzeichnet, dass** der Keramikkörper (14) zylinderförmig mit in Draufsicht rundem oder ellipsoidförmigem Querschnitt, prismenförmig oder quaderförmig ausgebildet ist, und dass die Ausnehmung (15) insbesondere konzentrisch durch den Keramikkörper (14) geführt ist.

4. Grüner keramischer Einsatzkörper nach einem der vorangehenden Ansprüche, **dadurch gekennzeichnet, dass** die Ausnehmung (15) zylinderförmig mit in Draufsicht rundem oder ellipsoidförmigem Querschnitt, prismenförmig oder quaderförmig ausgebildet ist, und dass sie aus dem Keramikkörper (14) herausstrukturiert, insbesondere ausgestanzt oder ausgebohrt, ist.

5. Grüner keramischer Einsatzkörper nach einem der vorangehenden Ansprüche, **dadurch gekennzeichnet, dass** die Paste (15') mit einem elektrisch leitfähigen Material wie Platin oder Aluminium gefüllt und derart in den Keramikkörper (14) eingefüllt ist, dass sie seine Oberfläche zumindest bereichsweise, insbesondere im Bereich einer oder beider der Austrittsöffnungen der Ausnehmung (15) aus dem Keramikkörper (14), überragt.

6. Grüner keramischer Einsatzkörper nach einem der vorangehenden Ansprüche, **dadurch gekennzeichnet, dass** der grüne Keramikkörper (14) als keramischen Bestandteil Aluminiumoxid enthält und/oder mittels Sintern zumindest weitgehend in einem keramischen Aluminiumoxidkörper überführbar ist.

7. Grüner keramischer Einsatzkörper nach einem der vorangehenden Ansprüche, **dadurch gekennzeichnet, dass** die Ausnehmung (15) einen Durchmesser von 50 µm bis 2 mm und/oder der grüne Keramikkörper (14) einen Durchmesser von 0,5 mm bis 5 mm aufweist.

8. Keramischer Einsatzkörper aus einem gesinterten grünen keramischen Einsatzkörper (20) nach einem der vorangehenden Ansprüche.

9. Keramischer Grünkörper oder Verbund keramischer Grünkörper, die oder der bereichsweise mindestens eine Aussparung (11) aufweist, in die ein grüner keramischer Einsatzkörper (20) nach einem der Ansprüche 1 bis 7 eingesetzt ist.

10. Keramischer Grünkörper oder Verbund keramischer Grünkörper nach Anspruch 9, **dadurch gekennzeichnet, dass** die Aussparung (11) in ihrer Dimensionierung an die Form des grünen keramischen Einsatzkörpers (20) angepasst oder geringfügig größer ist, und von einer Oberseite des Grünkörpers (5) oder des Grünkörperverbundes (5') zu einer Unterseite des Grünkörpers (5) oder des Grünkörperverbundes (5') führt oder diese miteinander verbindet.

11. Keramischer Grünkörper oder Verbund keramischer Grünkörper nach einem der Ansprüche 9 oder 10, **dadurch gekennzeichnet, dass**, abgesehen von dem Bereich der Aussparung (11), der Grünkörper (5) oder der Grünkörperverbund (5') Zirkoniumdioxid, insbesondere yttriumstabilisiertes Zirkoniumdioxid, als keramischen Bestandteil enthält und/oder mittels Sintern in einen Keramikkörper oder einen Keramikkörperschichtverbund überführbar ist, der, abgesehen von dem Bereich der Aussparung (11), im Wesentlichen aus Zirkoniumdioxid, insbesondere yttriumstabilisiertem Zirkoniumdioxid, besteht.

12. Keramischer Grünkörper oder Verbund keramischer Grünkörper nach einem der Ansprüche 9 bis 11, **dadurch gekennzeichnet, dass** im Bereich der Aussparung (11) auf der Innenwand (13) des Grünkörpers (5) oder des Grünkörperverbundes (5') zumindest bereichsweise eine Binderpaste (13') oder ein Schlicker vorgesehen ist.

13. Keramischer Grünkörper oder Verbund keramischer Grünkörper nach Anspruch 12, **dadurch gekennzeichnet, dass** die Innenwand (13) vollständig mit der Binderpaste (13') oder dem Schlicker versehen, insbesondere beschichtet, ist.

14. Keramischer Grünkörper oder Verbund keramischer Grünkörper nach einem der Ansprüche 9 bis 13, **dadurch gekennzeichnet, dass** er, abgesehen von dem Bereich der Aussparung (11), zumindest einseitig, insbesondere beidseitig, und zumindest bereichsweise mit einer grünen keramischen Isolationsschicht (12) versehen ist.

15. Keramischer Grünkörper oder Verbund keramischer Grünkörper nach einem der Ansprüche 9 bis 14, **dadurch gekennzeichnet, dass** er, abgesehen von dem Bereich der Aussparung, beidseitig vollständig mit der grünen keramischen Isolationsschicht (12) bedeckt ist.

16. Keramischer Grünkörper oder Verbund keramischer Grünkörper nach einem der Ansprüche 9 bis 15, **dadurch gekennzeichnet, dass** auf der Oberseite und/oder der Unterseite des Grünkörpers (5) oder des Verbundes keramischer Grünkörper (5') zumindest bereichsweise eine insbesondere flächig oder in Form einer Leitbahn strukturierte Leitpaste (16) vorgesehen ist, die auf der Oberseite und/oder der Unterseite mit der in den grünen Keramikkörper (14) eingefüllten Paste (15') in Verbindung steht.

17. Keramischer Grünkörper oder Verbund keramischer Grünkörper nach einem der Ansprüche 9 bis 16, **dadurch gekennzeichnet, dass** die Leitpaste (16) von dem keramischen Grünkörper (5) oder dem keramischen Grünkörperverbund (5') über die Isolationsschicht (12) getrennt ist.

18. Keramischer Schichtverbund aus einem gesinterten keramischen Grünkörper oder einem gesinterten Verbund keramischer Grünkörper nach einem der Ansprüche 9 bis 17.

19. Keramischer Schichtverbund nach Anspruch 18, **dadurch gekennzeichnet, dass** der keramische Einsatzkörper (20) stoffschlüssig mit dem keramischen Schichtverbund verbunden ist, wobei die durch das Sintern in eine Leiterbahn oder Leitfläche überführte Leitpaste (16) auf dem keramischen Schichtverbund elektrisch isoliert von diesem geführt ist und mittels der elektrischen Durchführung die Oberseite des Schichtverbundes elektrisch leitend mit der Unterseite des Schichtverbundes verbindet.

## Claims

1. Green ceramic insert having a green ceramic body (14) provided with a recess (15), the recess (15) passing through the green ceramic body (14) and being filled with a paste (15') which can be converted into an electrical leadthrough.

2. Green ceramic insert according to Claim 1, **characterized in that** the green ceramic body (14) can be converted, in particular by sintering, into a ceramic which is electrically nonconductive or weakly conductive compared to the electrical leadthrough.

3. Green ceramic insert according to Claim 1 or 2, **characterized in that** the ceramic body (14) is cylindrical in form, with a round or ellipsoidal cross section, as seen in plan view, or is in the shape of a prism or cuboid, and **in that** the recess (15) in particular leads concentrically through the ceramic body (14).

4. Green ceramic insert according to one of the preceding claims, **characterized in that** the recess (15) is cylindrical in form, with a round or ellipsoidal cross section as seen in plan view, or is in the form of a prism or cuboid, and **in that** it is structured, in particular stamped or drilled, out of the ceramic body (14).

5. Green ceramic insert according to one of the preceding claims, **characterized in that** the paste (15') is filled with an electrically conductive material, such as platinum or aluminium, and is introduced into the ceramic body (14) in such a manner that it projects beyond its surface at least in regions, in particular in the region of one or both of the outlet openings of the recess (15) from the ceramic body (14).

6. Green ceramic insert according to one of the preceding claims, **characterized in that** the green ceramic body (14) contains aluminium oxide as ceramic constituent and/or can be at least substantially converted into a ceramic aluminium oxide body by means of sintering.

7. Green ceramic insert according to one of the preceding claims, **characterized in that** the recess (15) has a diameter of from 50 µm to 2 mm and/or the green ceramic body (14) has a diameter of from 0.5 mm to 5 mm.

8. Ceramic insert formed from a sintered green ceramic insert (20) according to one of the preceding claims.

9. Ceramic green body or assembly of ceramic green bodies which, in regions, has at least one cutout (11) into which a green ceramic insert (20) according to one of Claims 1 to 7 is inserted.

10. Ceramic green body or assembly of ceramic green bodies according to Claim 9, **characterized in that** the dimensions of the cutout (11) are matched to or slightly larger than the shape of the green ceramic insert (20), and the cutout (11) leads from a top side of the green body (5) or the green body assembly (5') to an underside of the green body (5) or the green body assembly (5') or connects these sides to one another.

11. Ceramic green body or assembly of ceramic green bodies according to Claim 9 or 10, **characterized in that**, apart from the region of the cutout (11), the green body (5) or the green body assembly (5') contains zirconium dioxide, in particular yttrium-stabilized zirconium dioxide, as ceramic constituent and/or can be converted, by means of sintering into a ceramic body or a ceramic body layer assembly which, apart from the region of the cutout (11), substantially comprises zirconium dioxide, in particular yttrium-stabilized zirconium dioxide.

12. Ceramic green body or assembly of ceramic green bodies according to one of Claims 9 to 11, **characterized in that** in the region of the cutout (11) a binder paste (13') or a slip is provided at least in regions on the inner wall (13) of the green body (5) or the green body assembly (5').

13. Ceramic green body or assembly of ceramic green bodies according to Claim 12, **characterized in that** the inner wall (13) is completely provided, in particular coated, with the binder paste (13') or the slip.

14. Ceramic green body or assembly of ceramic green bodies according to one of Claims 9 to 13, **characterized in that**, apart from the region of the cutout (11), it is provided, at least on one side, in particular on both sides, and at least in regions, with a green ceramic insulation layer (12).

15. Ceramic green body or assembly of ceramic green bodies according to one of Claims 9 to 14, **characterized in that**, apart from the region of the cutout, it is completely covered on both sides with the green ceramic insulation layer (12).

16. Ceramic green body or assembly of ceramic green bodies according to one of Claims 9 to 15, **characterized in that** a conductive paste (16), which is patterned in particular aerially or in the form of a conductor track and is connected on the top side and/or the underside to the paste (15') that has been introduced into the green ceramic body (14), is provided at least in regions on the top side and/or the underside of the green body (5) or the assembly of ceramic green bodies (5').

17. Ceramic green body or assembly of ceramic green bodies according to one of Claims 9 to 16, **characterized in that** the conductive paste (16) is separated from the ceramic green body (5) or the ceramic green body assembly (5') by the insulation layer (12).

18. Ceramic layer assembly comprising a sintered ceramic green body or a sintered assembly of ceramic green bodies according to one of Claims 9 to 17.

19. Ceramic layer assembly according to Claim 18, **characterized in that** the ceramic insert (20) is cohesively joined to the ceramic layer assembly, the conductive paste (16), which has been converted into a conductor track or conductive surface by the sintering, being routed on the ceramic layer assembly, such that it is electrically insulated from the latter, and the top side of the layer assembly being electrically conductively connected to the underside of the layer assembly by means of the electrical leadthrough.

## Revendications

1. Insert céramique cru comprenant un corps céramique cru (14) muni d'un évidement (15) traversant le corps céramique cru (14) et rempli d'une pâte (15') pouvant être transformée en un passage électrique.

2. Insert céramique cru selon la revendication 1,
**caractérisé en ce que**
le corps céramique cru (14) peut être transformé, notamment par frittage, en une céramique non ou peu conductrice électriquement, vis-àvis du passage électrique.

3. Insert céramique cru selon la revendication 1 ou 2,
**caractérisé en ce que**
le corps céramique (14) présente une forme cylindrique d'une section transversale ronde ou elliptique en vue de dessus, de prisme ou de parallélépipède, et l'évidement (15) traverse le corps céramique (14) notamment de façon concentrique.

4. Insert céramique cru selon l'une quelconque des revendications précédentes,
**caractérisé en ce que**
l'évidement (15) présente une forme cylindrique d'une section transversale ronde ou elliptique en vue de dessus, de prisme ou de parallélépipède, et est structuré hors du corps céramique, notamment découpé ou percé.

5. Insert céramique cru selon l'une quelconque des revendications précédentes,
**caractérisé en ce que**
la pâte (15') est chargée d'un matériau conducteur électriquement tel que le platine ou l'aluminium et introduite dans le corps céramique (14) de sorte qu'elle saille de la surface de celui-ci, du moins partiellement, notamment dans la zone de l'une ou des deux oucruures de sortie de l'évidement (15) du corps céramique (14).

6. Insert céramique cru selon l'une quelconque des revendications précédentes,
**caractérisé en ce que**
le corps céramique cru (14) contient en tant que composante céramique de l'oxyde d'aluminium et/ou peut être transformé au moyen d'un frittage du moins en grande partie en un corps d'oxyde d'aluminium céramique.

7. Insert céramique cru selon l'une quelconque des revendications précédentes,
**caractérisé en ce que**
l'évidement (15) présente un diamètre compris entre 50 µm et 2 mm et/ou le corps céramique cru (14) a un diamètre compris entre 0,5 mm et 5 mm.

8. Insert céramique comprenant un insert céramique cru fritté (20) selon l'une quelconque des revendications précédentes.

9. Corps cru céramique ou composite de corps crus céramiques présentant par zones au moins un creux (11) dans lequel est inséré un insert céramique cru (20) selon l'une quelconque des revendications 1 à 7.

10. Corps cru céramique ou composite de corps crus céramiques selon la revendication 9,
**caractérisé en ce que**
le creux (11) est adapté au niveau de son dimensionnement à la forme de l'insert céramique cru (20) ou est légèrement plus grand, et conduit d'une face supérieure du corps cru (5) ou du composite de corps crus (5') vers une face inférieure du corps cru (5) ou du composite de corps crus (5'), ou relie les faces l'une à l'autre.

11. Corps cru céramique ou composite de corps crus céramiques selon l'une quelconque des revendications 9 ou 10,
**caractérisé en ce qu'**
à l'exception de la zone du creux (11), le corps cru (5) ou le composite de corps crus (5') contient du dioxyde de zirconium, notamment du dioxyde de zirconium stabilisé à l'yttrium, comme composante céramique et/ou peut être transformé au moyen de frittage en un corps céramique ou un composite stratifié de corps céramiques qui, à l'exception de la zone du creux (11), est constitué pour l'essentiel en dioxyde de Zirconium, notamment en dioxyde de Zirconium stabilisé à l'yttrium.

12. Corps cru céramique ou composite de corps crus céramiques selon l'une quelconque des revendications 9 à 11,
**caractérisé en ce qu'**
une pâte liante (13') ou une barbotine est prévue, au moins par zones, dans la zone de creux (11), sur la paroi intérieure (13) du corps cru (5) ou du composite de corps crus (5').

13. Corps cru céramique ou composite de corps crus céramiques selon la revendication 12,
**caractérisé en ce que**
la paroi intérieure (13) est entièrement munie, notamment recouverte de pâte liante (13') ou de barbotine.

14. Corps cru céramique ou composite de corps crus céramiques selon l'une quelconque des revendications 9 à 13,
**caractérisé en ce qu'**
à l'exception de la zone du creux (11), il est muni au moins sur une face, notamment sur les deux faces, et au moins par zones, d'une couche d'isolation céramique crue (12).

15. Corps cru céramique ou composite de corps crus céramiques selon l'une quelconque des revendications 9 à 14,
**caractérisé en ce qu'**
à l'exception de la zone du creux, il est entièrement recouverte sur les deux faces par la couche d'isolation céramique crue (12).

16. Corps cru céramique ou composite de corps crus céramiques selon l'une quelconque des revendications 9 à 15,
**caractérisé en ce qu'**
une pâte conductrice (16), notamment d'une structure plane ou sous la forme d'une piste conductrice, est prévue sur la face supérieure et/ou inférieure du corps cru (5) ou du composite de corps crus (5'), du moins par zones, qui est en communication avec la pâte (15') versée dans le corps céramique cru (14), sur la face supérieure et/ou la face inférieure.

17. Corps cru céramique ou composite de corps crus céramiques selon l'une quelconque des revendications 9 à 16,
**caractérisé en ce que**
la pâte conductrice (16) est séparée du corps cru céramique (5) ou du composite de corps crus céramiques (5') par la couche d'isolation (12).

18. Composite stratifiée céramique comprenant un corps cru céramique fritté ou un composite fritté de corps crus céramiques selon l'une quelconque des revendications 9 à 17.

19. Composite stratifiée céramique selon la revendication 18,
**caractérisée en ce que**
l'insert céramique (20) est relié au composite stratifiée céramique par complémentarité de matériaux, et la pâte conductrice (16) transformée par frittage en une piste conductrice ou surface conductrice est formée sur le composite stratifié céramique de façon électriquement isolée de celui-ci et relie de façon électriquement conductrice au moyen du passage électrique la face supérieure du composite stratifié à la face inférieure du composite stratifié.
